(19) Europäisches Patentamt

European Patent Office

Office européen des brevets

(11) **EP 3 308 183 B1**

## (12) FASCICULE DE BREVET EUROPEEN

(45) Date de publication et mention
de la délivrance du brevet:
**10.08.2022 Bulletin 2022/32**

(21) Numéro de dépôt: **16729869.4**

(22) Date de dépôt: **10.06.2016**

(51) Classification Internationale des Brevets (IPC):
**G01R 33/12** $^{(2006.01)}$

(52) Classification Coopérative des Brevets (CPC):
**G01R 33/1215**

(86) Numéro de dépôt international:
**PCT/EP2016/063319**

(87) Numéro de publication internationale:
**WO 2016/198614 (15.12.2016 Gazette 2016/50)**

(54) **PROCÉDÉ DE CONTRÔLE DE LA FABRICATION D'UN AIMANT ET DISPOSITIF ASSOCIÉ**

VERFAHREN ZUR STEUERUNG DER HERSTELLUNG EINES MAGNETEN UND ZUGEHÖRIGE VORRICHTUNG

METHOD FOR CONTROLLING THE PRODUCTION OF A MAGNET AND ASSOCIATED DEVICE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **10.06.2015 FR 1555294**

(43) Date de publication de la demande:
**18.04.2018 Bulletin 2018/16**

(73) Titulaire: **Commissariat à l'Energie Atomique et aux Energies Alternatives**
**75015 Paris (FR)**

(72) Inventeurs:
• **ALCOUFFE, François**
**38000 Grenoble (FR)**
• **VIANA, Antonio**
**38320 Herbeys (FR)**

(74) Mandataire: **Lavoix**
**2, place d'Estienne d'Orves**
**75441 Paris Cedex 09 (FR)**

(56) Documents cités:
**US-A1- 2011 025 311    US-A1- 2014 176 126**

EP 3 308 183 B1

**Description**

DOMAINE TECHNIQUE DE L'INVENTION

La présente invention concerne un procédé de contrôle de la fabrication d'un aimant à symétrie de révolution par rapport à un axe. La présente demande se rapporte également au dispositif associé.

ARRIERE-PLAN TECHNOLOGIQUE

Un aimant permanent, ou aimant dans le langage courant, est un objet fabriqué dans un matériau magnétique dur, c'est-à-dire dont le champ rémanent et l'excitation coercitive sont grands. Cela donne à l'aimant des propriétés particulières liées à l'existence du champ magnétique, comme la capacité d'exercer une force d'attraction sur tout matériau ferromagnétique.

De telles propriétés permettent d'employer l'aimant dans différents contextes applicatifs. En particulier, le document EP 1 813 910 A2 décrit un système de détection de la position d'un véhicule à l'aide de la caractérisation d'aimant alors que le document US-2011/0025311 A1 est relatif à un système de caractérisation d'une roue magnétique.

Toutefois, l'utilisation d'un aimant dans de tels contextes suppose que l'aimant respecte un cahier des charges donné.

En particulier, il est souhaitable que l'induction électromagnétique générée par l'aimant ait la valeur désirée pour assurer que l'aimant considéré ait la capacité d'exercer une force d'attraction suffisante par rapport à l'application désirée.

Or, la fabrication d'un aimant est délicate puisque, pour un aimant ayant les bonnes dimensions mécaniques, les propriétés magnétiques peuvent sensiblement varier et, en particulier, être en dehors des plages de tolérance permises. De telles variations proviennent notamment de l'anisotropie des matériaux utilisés ou de la capacité à s'aimanter des matériaux utilisés.

Il est également connu du document US 2014/176126 des agencements et procédés de capteurs de champ magnétique fournissant un capteur de champ magnétique positionné à proximité d'un aimant avec un axe de sensibilité aligné par rapport à l'aimant dans des orientations qui offrent une bonne sensibilité et une différence mécanique par rapport aux autres agencements. Le document US2014176126A décrit un procédé de contrôle comprenant une étape de mesure d'une composante de l'induction magnétique produite par un aimant à l'aide d'un capteur en mettant en oeuvre les sous-étapes suivantes: - positionner le capteur pour que l'axe de mesure du capteur soit perpendiculaire à l'axe mécanique de l'aimant et soit dans un plan perpendiculaire à l'axe mécanique de l'aimant passant par un point de l'aimant, - faire tourner l'aimant par rapport à l'axe mécanique d'au moins un tour, - mesurer les inductions magnétiques. Le document US2014176126A décrit aussi un dispositif de contrôle.

Il existe donc un besoin pour un procédé de contrôle de la fabrication d'un aimant qui soit efficace et de mise en oeuvre aisée.

RESUME DE L'INVENTION

Pour cela, il est proposé un procédé de contrôle de la fabrication d'un aimant à l'aide d'un capteur propre à émettre un signal de présence d'une induction magnétique et définissant un axe de mesure, l'aimant étant un aimant permanent à symétrie de révolution par rapport à son axe, dit axe mécanique, l'aimant ayant un centre et une dimension maximale, le procédé comprenant au moins l'étape suivante :

a) réaliser une première mesure d'une composante de l'induction magnétique produite par l'aimant à l'aide du capteur en mettant en oeuvre les sous-étapes suivantes :

a1) positionner relativement l'aimant et le capteur pour que l'axe mécanique de l'aimant et l'axe de mesure du capteur soient alignés avec une tolérance de 5 degrés, la distance entre le capteur et le centre de l'aimant, dite première distance, étant supérieure ou égale à trois fois la dimension maximale de l'aimant et

a2) déplacer relativement l'aimant et le capteur, selon une direction perpendiculaire à l'axe mécanique de l'aimant, la première mesure correspondant au signal maximal mesuré par le capteur lors du déplacement,

b) réaliser une deuxième mesure d'une composante de l'induction magnétique produite par l'aimant à l'aide du capteur en mettant en oeuvre les sous-étapes suivantes :

b1) positionner le capteur pour que l'axe de mesure du capteur soit perpendiculaire à l'axe mécanique de l'aimant et soit dans un plan perpendiculaire à l'axe mécanique de l'aimant passant par un point de l'aimant, la distance entre le capteur et le centre de l'aimant, dite deuxième distance, étant supérieure ou égale à trois fois la dimension maximale de l'aimant,
b2) faire tourner l'aimant par rapport à l'axe mécanique d'au moins un tour,
b3) mesurer les inductions magnétiques maximale et minimale lors de la rotation de l'aimant à la sous-étape b2), la deuxième mesure étant obtenue à partir des inductions magnétiques maximale et minimale, et

c) calculer la déviation angulaire du moment magnétique équivalent de l'aimant à partir de la première mesure et de la deuxième mesure.

Suivant des modes de réalisation particuliers, le procédé de contrôle comprend une ou plusieurs des caractéristiques suivantes, prise(s) isolément ou suivant toutes les combinaisons techniquement possibles :

- la première distance est supérieure ou égale à dix fois la dimension maximale de l'aimant.
- la deuxième distance est supérieure ou égale à dix fois la dimension maximale de l'aimant.
- à l'étape a1), l'aimant et le capteur sont positionnés relativement pour que l'axe mécanique de l'aimant soit aligné avec l'axe de mesure du capteur.
- à l'étape b1), l'aimant et le capteur sont positionnés relativement pour que l'axe mécanique de l'aimant soit perpendiculaire avec l'axe de mesure du capteur.
- la deuxième mesure est obtenue en calculant le ratio entre la différence des inductions magnétiques maximale et minimale mesurées à la sous-étape b3) et le nombre 2.
- l'étape c) comporte une sous-étape c1) d'application de la formule suivante :

$$\alpha = \tan^{-1}\frac{B_2}{B_1}$$

où :

- $B_1$ est la valeur de la composante obtenue à l'étape a),
- $B_2$ est la valeur de la composante obtenue à l'étape b),
- $\alpha$ est la déviation angulaire du moment équivalent par rapport à la verticale de l'induction rémanente de l'aimant, et
- $\tan^{-1}$ est l'opération mathématique aussi appelée arctangente.

- l'étape c) comporte une sous-étape c2) de calcul du module du moment équivalent de l'aimant par application de la formule suivante :

$$m = \frac{4\pi r^3}{2\mu_0} * \sqrt{B_1^2}$$

où :

- m est le module du moment équivalent de l'aimant,
- r est la distance arithmétique moyenne de la première distance et de la deuxième distance, et
- $\mu_0$ est la perméabilité magnétique du vide.

- le procédé comporte, en outre, une étape d) de comparer la déviation angulaire calculée à une valeur seuil, l'aimant étant considéré comme valable lorsque la déviation angulaire est inférieure ou égale à la valeur seuil.

L'invention concerne aussi un dispositif de contrôle de la fabrication d'un aimant, l'aimant étant un aimant permanent à symétrie de révolution par rapport à un axe, dit axe mécanique, l'aimant ayant un centre et une dimension maximale, le dispositif comprenant :

- un capteur propre à émettre un signal en présence d'une induction magnétique et définissant un axe de mesure, le capteur étant propre à réaliser une première mesure d'une composante de l'induction magnétique produite par l'aimant et à réaliser une deuxième mesure d'une composante de l'induction magnétique produite par l'aimant,
- un premier organe de positionnement relatif de l'aimant et du capteur pour que l'axe mécanique de l'aimant et l'axe de mesure du capteur soient alignés avec une tolérance de 5 degrés, la distance entre le capteur et le centre de l'aimant, dite première distance, étant supérieure ou égale à trois fois la dimension maximale, de l'aimant,

- un premier organe de déplacement relatif de l'aimant et du capteur selon une direction perpendiculaire à l'axe mécanique de l'aimant, la première mesure correspondant au signal maximal mesuré par le capteur lors du déplacement,
- un deuxième organe de positionnement du capteur pour que l'axe de mesure du capteur soit perpendiculaire à l'axe mécanique de l'aimant et soit dans un plan perpendiculaire à l'axe mécanique de l'aimant passant par un point de l'aimant, la distance entre le capteur et le centre de l'aimant, dite deuxième distance, étant supérieure ou égale à trois fois la dimension maximale, de l'aimant,
- un organe de rotation de l'aimant par rapport à l'axe mécanique sur au moins un tour,
- un organe de mesure des inductions magnétiques maximale et minimale lors de la rotation de l'aimant par l'organe de rotation,
- un organe d'obtention de la deuxième mesure à partir des inductions magnétiques maximale et minimale, et
- une unité de traitement pour calculer la déviation angulaire du moment magnétique équivalent de l'aimant à partir de la première mesure et de la deuxième mesure.

Suivant des modes de réalisation particuliers, le dispositif de contrôle comprend une ou plusieurs des caractéristiques suivantes, prise(s) isolément ou suivant toutes les combinaisons techniquement possibles :

- la première distance est supérieure ou égale à dix fois la dimension maximale de l'aimant.
- la deuxième distance est supérieure ou égale à dix fois la dimension maximale de l'aimant.

BREVE DESCRIPTION DES DESSINS

D'autres caractéristiques et avantages de l'invention apparaîtront à la lecture de la description qui suit de mode de réalisation de l'invention, donnée à titre d'exemple uniquement et en référence aux dessins qui sont :

- figure 1, une représentation schématique d'un exemple de dispositif de contrôle de la fabrication d'un aimant,
- figure 2, une représentation schématique d'une étape d'un procédé de contrôle de la fabrication d'un aimant,
- figure 3, une représentation schématique d'une autre étape d'un procédé de contrôle de la fabrication d'un aimant,
- figure 4, un graphique présentant l'effet sur l'induction d'une déviation angulaire entre l'axe du moment magnétique et l'axe mécanique d'un aimant en fonction de cette déviation angulaire,
- figure 5, une représentation schématique des positions de mesure pour un exemple de mise en oeuvre d'un procédé de contrôle,
- figure 6, une représentation schématique d'un autre exemple de dispositif de contrôle de la fabrication d'un aimant permettant la mise en oeuvre du procédé de contrôle de la figure 5, et
- figure 7, une représentation schématique des positions de mesure pour un autre exemple de mise en oeuvre d'un procédé de contrôle.

DESCRIPTION DETAILLEE DE MODES DE REALISATION DE L'INVENTION

*Description d'un exemple de mode de réalisation*

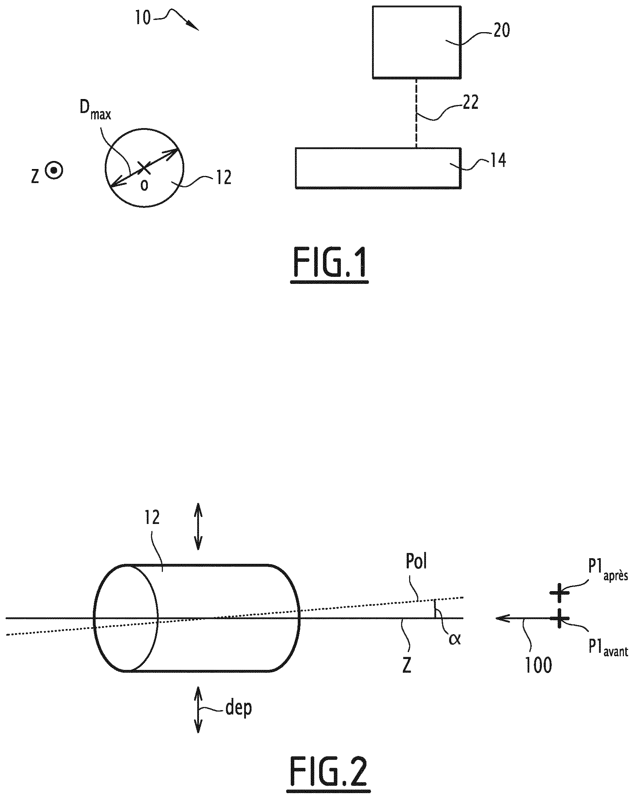

Un dispositif 10 de contrôle de la fabrication d'un aimant 12 est représenté à la figure 1.

Le dispositif 10 est propre à caractériser les propriétés de l'aimant 12 et à déterminer ainsi si la qualité de fabrication de l'aimant 12 est satisfaisante ou non.

Le dispositif 10 est propre à mettre en oeuvre un procédé de contrôle de la fabrication de l'aimant 12 qui est à entendre comme un procédé de caractérisation de l'aimant 12.

Selon l'exemple de la figure 1, le dispositif 10 est un dispositif permettant d'obtenir la mesure du moment magnétique M équivalent de l'aimant 12. En ce sens, le dispositif 10 forme un banc de caractérisation.

Par définition, le moment magnétique équivalent d'un aimant est le moment magnétique générant une induction magnétique présentant les mêmes propriétés que l'induction magnétique que l'aimant est propre à générer. Le moment magnétique équivalent d'un aimant est caractérisé par deux grandeurs, à savoir son intensité ou son module et sa direction.

L'aimant 12 est propre à générer en tout point de l'espace une induction magnétique.

L'aimant 12 est un aimant permanent.

En outre, l'aimant 12 est un aimant à symétrie de révolution par rapport à un axe. L'axe est appelé axe mécanique dans la suite de la description et est noté Z.

L'aimant 12 est également polarisé suivant un axe de polarisation. L'axe de polarisation est noté Pol dans la suite. L'axe de polarisation Pol est visible notamment sur la figure 2.

Il est à noter que l'axe de polarisation Pol et l'axe mécanique Z forme un angle qui correspond à la déviation angulaire du moment magnétique M équivalent à l'aimant 12.

Par exemple, comme visible à la figure 1, l'aimant 12 est un aimant cylindrique à base circulaire.

De plus, l'aimant 12 est réalisé en un matériau magnétique homogène. Un matériau magnétique est considéré comme homogène lorsque les propriétés magnétiques du matériau magnétique ne dépendent pas de l'endroit où les propriétés magnétiques sont évaluées

L'aimant 12 possède un centre noté O.

Il est défini, pour la suite de la description, un plan de mesure $P_{mesure}$. Le plan de mesure $P_{mesure}$ est le plan perpendiculaire à l'axe mécanique Z et passant par le centre O de l'aimant 12.

L'aimant 12 présente une dimension maximale $D_{max}$. Par définition, la dimension maximale d'un aimant est la plus grande distance euclidienne entre deux points de l'aimant 12.

Le dispositif 10 comporte un capteur 14 et une unité de traitement 20.

Le capteur 14 est propre à mesurer l'induction magnétique existant à une position donnée. Le capteur 14 est, plus précisément, propre à générer un signal ou plusieurs signaux proportionnel(s) à l'induction magnétique mesurée à une position donnée.

A titre d'exemple, le capteur 14 génère un signal proportionnel à l'amplitude de chaque composante de l'induction magnétique.

L'unité de traitement 20 est également propre à récolter des données issues du capteur 14 comme l'indiquent les premiers traits pointillés 22.

Plus précisément, l'unité de traitement 20 est propre à récolter les signaux issus du capteur 14 pour en déduire chaque composante de l'induction magnétique que l'aimant 12 est propre à générer.

L'unité de traitement 20 est propre à effectuer des calculs à partir des signaux récoltés pour en déduire le moment magnétique M équivalent à l'aimant 12, et notamment la direction du moment magnétique équivalent, c'est-à-dire la déviation angulaire par rapport à l'axe mécanique Z. Pour la suite, la déviation angulaire est notée a.

A titre d'exemple, l'unité de traitement 20 est un processeur.

Le fonctionnement du dispositif 10 visible sur la figure 1 va à présent être décrit en référence à un exemple de mise en oeuvre d'un procédé de contrôle de la fabrication de l'aimant 12.

Par exemple, le procédé de contrôle comprend trois étapes successives : une étape a) de réalisation d'une première mesure, une étape b) de réalisation d'une deuxième mesure et une étape c) de calcul de la déviation angulaire α du moment magnétique M équivalent à l'aimant 12.

D'autres ordres sont également envisageables. En particulier, l'étape a) de réalisation d'une première mesure et l'étape b) de réalisation d'une deuxième mesure sont interchangeables.

A l'étape a) de réalisation de la première mesure, la composante produite par l'aimant 12 à une première position P1 est mesurée.

La première position P1 appartient au plan de mesure $P_{mesure}$.

L'étape a) de réalisation de la première mesure comporte deux sous-étapes : une première sous-étape a1) de positionnement relatif et une deuxième sous-étape a2) de déplacement relatif.

La première sous-étape a1) est, par exemple, mise en oeuvre par un premier organe de positionnement.

A la sous-étape a1) de positionnement relatif, l'aimant 12 et le capteur 14 sont positionnés relativement l'un à l'autre pour que l'axe mécanique Z de l'aimant 12 soient alignés avec une tolérance de à 5 degrés près.

En outre, la distance OP1 entre le capteur 14 et le centre O de l'aimant 12, dite première distance, étant supérieure ou égale à dix fois la dimension maximale $D_{max}$, de l'aimant 12.

Ceci s'écrit mathématiquement comme $OP1 \geq 10*D_{max}$ où '*' désigne l'opération mathématique du produit.

De préférence, la distance OP1 entre la première position P1 et le centre O de l'aimant 12 est inférieure ou égale à vingt fois la dimension maximale $D_{max}$ de l'aimant 12. Ceci s'écrit mathématiquement comme $OP1 \leq 20*D_{max}$.

Avantageusement, la distance OP1 entre la première position P1 et le centre O de l'aimant 12 est égale à quinze fois la dimension maximale $D_{max}$ de l'aimant 12. Ceci s'écrit mathématiquement comme $OP1 = 15*D_{max}$. La valeur de $15*D_{max}$ correspond à un compromis entre, d'une part, une bonne validité de l'approximation dipolaire et, d'autre part, une mise en œuvre aisée de la mesure.

La sous-étape a1) est notamment mise en œuvre par un premier organe de positionnement.

Lors de la sous-étape a2), il est déplacé relativement l'aimant 12 et le capteur 14 selon une direction perpendiculaire à l'axe mécanique Z de l'aimant 12. Un tel déplacement est montré schématiquement sur la figure 2 sur laquelle une flèche est indiquée dep.

La première mesure B1 correspond au signal maximal mesuré par le capteur 14 lors du déplacement.

La sous-étape a2) est notamment mise en œuvre par un premier organe de déplacement.

L'étape a) de réalisation de la première mesure est mise en œuvre à l'aide du capteur 14 et permet la première mesure de l'induction magnétique. La première mesure de l'induction magnétique est notée B1.

A l'étape de réalisation de la deuxième mesure, la composante produite par l'aimant 12 en une deuxième position P2 est mesurée.

La deuxième position P2 appartient au plan de mesure P$_{mesure}$.

L'étape b) de réalisation de la deuxième mesure comporte trois sous-étapes : une première sous-étape b1) de positionnement, une deuxième sous-étape b2) de rotation et une troisième sous-étape b3) de mesure.

A la première sous-étape b1), le capteur est positionné pour que l'axe de mesure du capteur soit perpendiculaire à l'axe de mécanique de l'aimant et soit dans un plan perpendiculaire à l'axe mécanique de l'aimant passant par un point de l'aimant.

De plus, la distance OP2 entre la deuxième position P2 et le centre géométrique O de l'aimant 12 est supérieure ou égale à dix fois la dimension maximale D$_{max}$ de l'aimant 12. Ceci s'écrit mathématiquement comme OP2 $\geq$ 10*D$_{max}$.

De préférence, la distance OP2 entre la deuxième position P2 et le centre O de l'aimant 12 est inférieure ou égale à vingt fois la dimension maximale D$_{max}$ de l'aimant 12. Ceci s'écrit mathématiquement comme OP2 $\leq$ 20*D$_{max}$.

Avantageusement, la distance OP2 entre la deuxième position P2 et le centre O de 12 est égale à quinze fois la dimension maximale D$_{max}$ de l'aimant 12. Ceci s'écrit mathématiquement comme OP2 = 15*D$_{max}$. La valeur de 15*D$_{max}$ correspond à un compromis entre, d'une part, une bonne validité de l'approximation dipolaire et, d'autre part, une mise en oeuvre aisée de la mesure.

La première sous-étape b1) est mise en oeuvre par un deuxième organe de positionnement.

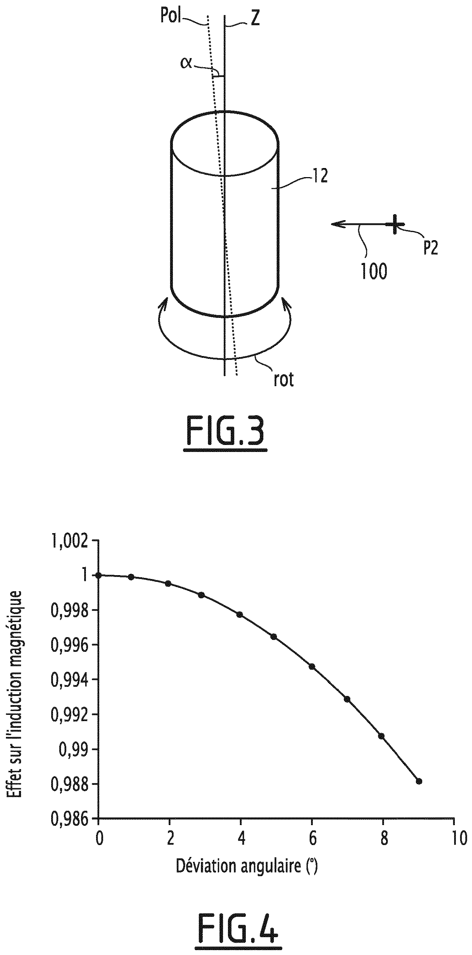

Lors de la deuxième sous-étape b2), l'aimant 12 est tourné par rapport à l'axe mécanique d'au moins tour comme illustré schématiquement à la figure 3.

Par exemple, la deuxième sous-étape b2) est mise en oeuvre à l'aide d'un organe de rotation de l'aimant 12.

Lors de la troisième sous-étape b3), il est mesuré les inductions magnétiques maximale et minimale lors de la rotation de l'aimant 12 à la sous-étape b2), la deuxième mesure B2 étant obtenue à partir des inductions magnétiques maximale et minimale.

La troisième sous-étape b3) est mise en oeuvre en utilisant, par exemple, un organe de mesure et un organe d'obtention.

L'étape de deuxième mesure est mise en oeuvre à l'aide du capteur 14 qui permet d'obtenir la valeur de la composante de l'induction magnétique produite par l'aimant 12 à la deuxième position P2.

A l'issue de l'étape de deuxième mesure, il est obtenu une deuxième mesure de l'induction magnétique. La deuxième mesure de l'induction magnétique est notée B2.

L'étape c) de calculer la déviation angulaire $\alpha$ du moment magnétique M équivalent de l'aimant 12 est mise en oeuvre par l'unité de traitement 20 à partir de la première mesure B1 et de la deuxième mesure B2.

Pour cela, l'induction magnétique de l'aimant 12 est assimilée à un dipôle magnétique dont le moment magnétique est le moment magnétique M équivalent de l'aimant 12. En utilisant l'approximation dipolaire, il est possible de déduire de deux mesures d'induction distinctes le module du moment magnétique équivalent ainsi que la direction du moment magnétique équivalent, c'est-à-dire la déviation angulaire $\alpha$ par rapport à l'axe mécanique Z.

Le procédé de contrôle permet donc d'obtenir le moment magnétique M équivalent de l'aimant 12 à la fois en amplitude et en direction.

La mise en oeuvre du procédé de contrôle est aisée puisque que seules deux mesures de l'induction magnétique de l'aimant 12 sont impliquées.

De plus, le procédé de contrôle est un procédé robuste permettant d'obtenir une bonne précision dans la mesure de la déviation angulaire $\alpha$ du moment magnétique M équivalent d'un aimant 12.

Selon un mode de réalisation, la mesure de la déviation angulaire $\alpha$ du moment magnétique M est utilisée comme indicateur de la qualité de la fabrication de l'aimant 12.

En effet, il est possible de quantifier l'effet sur l'induction magnétique produite par l'aimant 12 de la valeur de la déviation angulaire a. Le graphique de la figure 4 illustre une telle quantification puisque la variation de la valeur de l'induction magnétique normalisée est représentée en fonction de la valeur de la déviation angulaire.

A l'examen de la figure 4, il apparaît qu'une valeur de déviation angulaire de 8° résulte en une estimation du moment magnétique M qui est faussée de 1%. Cela semble donc indiquer que les contraintes d'alignement (pour l'étape a) de réalisation d'une première mesure imposent un alignement d'au plus 8° pour obtenir une bonne précision.

Aussi, dans un exemple particulier, le procédé comporte, en outre, une étape de comparaison de la déviation angulaire calculée à une valeur seuil, l'aimant 12 étant considéré comme valable lorsque la déviation angulaire est inférieure ou égale à la valeur seuil.

Comme expliqué en regard de la figure 4, il est avantageux de proposer une valeur seuil de plus ou moins 8°.

*Description d'un exemple particulier de mode de réalisation*

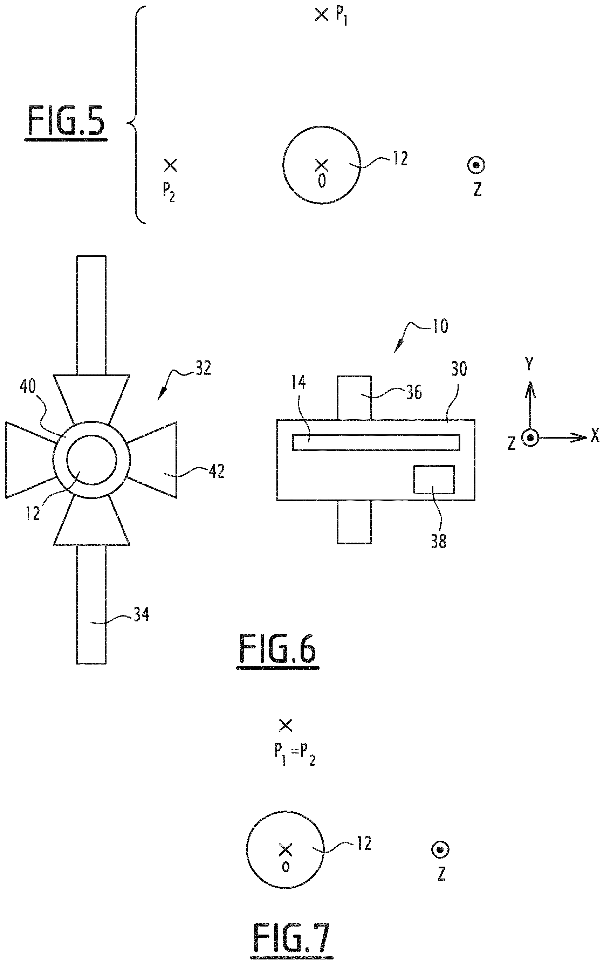

Selon le mode de réalisation illustré par la figure 5, la deuxième position P2 est distincte de la première position P1.

De plus, la distance OP1 entre la première position P1 et le centre géométrique O de l'aimant 12 et la distance OP2 entre la deuxième position P2 et le centre géométrique O de l'aimant 12 sont égales à plus ou moins 1%.

Avantageusement, comme c'est le cas dans la figure 5, la distance OP1 entre la première position P1 et le centre géométrique O de l'aimant 12 et la distance OP2 entre la deuxième position P2 et le centre géométrique O de l'aimant 12 sont égales. Cela s'écrit mathématique comme OP1 = OP2.

Un tel procédé présente l'avantage d'être aisément mis en oeuvre, et notamment par le dispositif 10 tel qu'illustré à la figure 6.

Le dispositif 10 de la figure 6 comprend les mêmes éléments que le dispositif 10 de la figure 1.

En outre, le dispositif 10 de la figure 6 comporte un magnétomètre 30 comprenant le capteur 14, un premier support 32 destiné à supporter l'aimant 12, un organe de guidage 34 du premier support 32 et un deuxième support 36 destiné à supporter le capteur 14.

Le magnétomètre 30 comporte le capteur 14 et une unité électronique 38.

Le magnétomètre 30 est un appareil qui sert à mesurer l'induction magnétique ou l'aimantation d'un dispositif. Le magnétomètre 30 repose sur un élément sensible à l'induction magnétique qui est, en l'occurrence, le capteur 14 de induction magnétique qui associé à l'unité électronique 38, permet d'extraire la mesure de l'induction magnétique. Il en existe différents types, basés sur des principes physiques différents.

Selon l'exemple de la figure 6, le magnétomètre 30 est un magnétomètre fluxgate.

Avantageusement, comme c'est le cas pour l'exemple de la figure 6, le magnétomètre 30 est un magnétomètre vectoriel mono-axial.

Il est entendu par l'expression « magnétomètre vectoriel mono-axial » que le magnétomètre est propre à fournir une composante de l'induction magnétique. Plus précisément, le capteur mono-axial mesure la valeur de la composante de l'induction magnétique parallèle à l'axe du capteur 14.

Aussi, pour le magnétomètre 30, il est défini pour la suite un axe de mesure qui est appelé « axe du capteur 14 ». L'axe du capteur 14 est symbolisé par un axe X sur la figure 6.

Le premier support 32 est propre, selon l'exemple de la figure 6, à tourner autour de l'axe mécanique Z.

Selon l'exemple de la figure 6, le premier support 32 comporte une base 40 de réception et des branches 42.

La base 40 est propre à recevoir l'aimant 12.

Comme visible à la figure 6, la base 40 a la forme d'un cylindre dont la base est un disque.

Les branches 42 s'étendant radialement depuis la base 40.

Dans le cas de la figure 6, les branches 42 sont au nombre de quatre, deux à deux opposées et s'étendent radialement depuis la base 40. Dans une section en parallèle au plan de mesure $P_{mesure}$, le premier support 32 a la forme d'une croix de Malte. Autrement formulé, l'étendue des branches 42 va en diminuant vers la base 40.

D'autres formes pour la base 40 sont également envisageables.

Le premier support 32 est réalisé dans un matériau amagnétique.

Le premier support 32 est, de préférence, obtenu par un procédé d'impression tridimensionnelle.

L'organe de guidage 34 est propre à permettre un déplacement en translation du premier support 32 et à permettre la rotation du premier support 32 sur lui-même.

L'organe de guidage 34 est un rail optique. Le rail 34 est réalisé en aluminium, ce qui permet d'obtenir un dispositif 10 amagnétique.

Dans le cas particulier de la figure 6, le rail 34 a la forme d'un profilé en X.

Le rail 34 s'étend principalement le long d'une direction perpendiculaire à l'axe du capteur 14. La direction associée est appelée direction du rail 34 dans la suite de la description et est symbolisé par un axe Y sur la figure 6.

Selon l'exemple de la figure 6, le deuxième support 36 est fixe.

Selon un mode de réalisation, le deuxième support 36 est rotatif autour de l'axe mécanique Z alors que le premier support 32 est fixe.

Selon encore un autre mode de réalisation, les deux supports 32 et 36 sont propres à tourner autour de l'axe mécanique Z.

Le fonctionnement du dispositif de la figure 6 va à présent être décrit en référence à un exemple de mise en oeuvre d'un procédé de contrôle de la fabrication de l'aimant 12.

Dans un tel exemple, le procédé de contrôle comprend quatre étapes successives : une étape de prise en compte de l'induction magnétique ambiante, une étape de première mesure, une étape de deuxième mesure et une étape de calcul de la déviation angulaire $\alpha$ moment magnétique M.

A l'étape de prise en compte de l'induction magnétique ambiante, le magnétomètre 30 est positionné dans le deuxième support 36 en position de fonctionnement. Le magnétomètre 30 mesure une induction magnétique ambiante non nulle. Le magnétomètre 30 compense alors l'induction magnétique ambiante mesurée à l'aide d'une fonction de décalage (aussi désignée par le terme « offset » en anglais) de sorte que le magnétomètre 30 mesure une induction magnétique nulle même en présence de l'induction magnétique ambiante.

En variante, le magnétomètre 30 est positionné dans le deuxième support 36 en position de fonctionnement. En pratique, la mesure du capteur 14 n'est pas forcément nulle, car l'induction magnétique ambiante, qui est un vecteur, se projette sur l'axe de mesure du capteur 14. Toutefois, il existe deux positions pour lesquelles la projection de l'induction magnétique ambiante est égale à zéro. Les deux positions sont de même direction et opposées en sens. Afin de converger vers les deux positions, l'ensemble du dispositif 10 est tourné autour de l'axe mécanique Z jusqu'à parvenir à une des deux positions.

Selon un autre mode de réalisation, le dispositif 10 est d'abord tourné autour de l'axe mécanique Z jusqu'à parvenir à une des deux positions puis, le magnétomètre 30 compense l'induction magnétique ambiante résiduelle. Dans un tel mode de réalisation, se suivent donc un réglage grossier et un réglage fin, ce qui permet d'obtenir une compensation fine de l'induction magnétique ambiante.

L'étape de prise en compte de l'induction magnétique ambiante permet que, lors de la mise en oeuvre des étapes de mesure, le magnétomètre 30 mesure uniquement la contribution de l'aimant 12 à l'induction magnétique.

Les remarques relatives à l'étape de première mesure telle que précédemment décrite s'appliquent également pour la présente étape de première mesure.

De plus, dans le cas particulier du dispositif 10 de la figure 6, l'aimant 12 est agencé dans une première position particulière appelée la première position de Gauss G1. Lors de l'étape de première mesure, l'aimant 12 est déplacé d'une extrémité à l'autre de l'organe de guidage 34 et l'induction magnétique est mesurée simultanément par le capteur 14. Le maximum de la mesure relevée donne la valeur de l'induction magnétique générée par l'aimant 12 à la première position de Gauss G1.

Ainsi, lors de l'étape de première mesure, le signal mesuré par le capteur 14 est maximal lorsque l'aimant 12 est parallèle au capteur 14.

Les remarques relatives à l'étape de deuxième mesure telle que précédemment décrite s'appliquent également pour la présente étape de deuxième mesure.

La deuxième position P2 est la seconde position de Gauss G2.

Pour obtenir la valeur de l'induction magnétique générée par l'aimant 12 à la deuxième position de Gauss G2, deux valeurs d'inductions magnétiques sont mesurées. Alors que l'aimant 12 est tourné autour de l'axe mécanique Z, la valeur maximale $B_{max}$ que prend l'induction magnétique ainsi que la valeur maximale $B_{min}$ que prend l'induction magnétique sont relevées. La valeur de l'induction magnétique générée par l'aimant 12 à la deuxième position de Gauss G2 s'obtient en calculant la différence entre la valeur maximale et la valeur minimale de champ divisée par deux. Ceci s'écrit mathématiquement comme :

$$B_2 = \frac{1}{2}(B_{max} - B_{min})$$

A l'étape de calcul de la déviation angulaire $\alpha$ du moment magnétique M équivalent à partir de la première mesure B1 et de la deuxième mesure B2, la déviation angulaire du moment équivalent par rapport à la verticale de l'induction rémanente de l'aimant 12 est donnée par la formule suivante :

$$\alpha = \tan^{-1}\frac{B_2}{B_1}$$

Où:

- $\alpha$ est la déviation angulaire du moment équivalent par rapport à la verticale de l'induction rémanente de l'aimant 12, et
- $\tan^{-1}$ est l'opération mathématique aussi appelée arctangente.

La précédente formule se simplifie lorsque le rapport B2/B1 est faible, ce qui est usuellement le cas en pratique selon la forme approximée suivante :

$$\alpha = \frac{B_2}{B_1}$$

L'étape de calcul du moment magnétique comprend alors le calcul du module du moment magnétique équivalent par application de la formule suivante :

$$m = \frac{4\pi r^3}{2\mu_0} * \sqrt{B_1^2}$$

Où:

- m est le module du moment équivalent de l'aimant 12,
- r est la distance arithmétique moyenne de OP1 et OP2, et
- $\mu_0$ est la perméabilité magnétique du vide.

Il est à noter que, de préférence, l'égalité OP1 = OP2 est vérifiée.

En effet, il est à noter qu'une erreur de 1% sur la distance (soit OP1 = 99%*OP2 ou OP1 = 101%*OP2) induit une erreur de 3% sur l'estimation des grandeurs magnétiques. Une erreur de 2% sur la distance induirait de même une erreur de 6% sur l'estimation des grandeurs magnétiques. De ce fait, il est souhaitable de reproduire les distances sans biais pour que la mesure soit fiable.

Le procédé de contrôle permet donc d'obtenir le moment magnétique équivalent de l'aimant 12 à la fois en amplitude et en direction.

La mise en oeuvre du procédé de contrôle est aisée puisque que seules deux mesures de l'induction magnétique de l'aimant 12 sont impliquées.

De plus, le procédé de contrôle est un procédé robuste permettant d'obtenir une bonne précision dans la mesure de la déviation angulaire $\alpha$ du moment magnétique équivalent d'un aimant 12.

Le procédé de contrôle de la fabrication d'un aimant 12 est ainsi un procédé de caractérisation d'un aimant 12.

Il est à noter que le procédé de contrôle fonctionne aussi pour une première distance OP1 supérieure ou égale à trois fois la dimension maximale $D_{max}$ de l'aimant 12. Avec ce facteur 3, il est obtenu une bonne approximation de la déviation angulaire. Le cas où le facteur est de 10 permet d'améliorer la précision.

Similairement, le procédé de contrôle fonctionne aussi pour une deuxième distance OP2 supérieure ou égale à trois fois la dimension maximale $D_{max}$ de l'aimant 12. Avec ce facteur 3, il est obtenu une bonne approximation de la déviation angulaire. Le cas où le facteur est de 10 permet d'améliorer la précision.

Le procédé fonctionne également pour la combinaison des deux conditions précédentes à savoir une première distance OP1 supérieure ou égale à trois fois la dimension maximale $D_{max}$ de l'aimant 12 et une deuxième distance OP2 supérieure ou égale à trois fois la dimension maximale $D_{max}$ de l'aimant 12.

*Résultats expérimentaux*

Une expérience a été menée et a montré que le procédé illustré en référence à la figure 2 permet d'obtenir de bons résultats de mesures.

Un prototype mettant en application les résultats présentés précédemment a été construit. Nous avons utilisé un capteur axial de type FluxGate Förster Magnetoscop.

La demanderesse a réalisé une série de mesures en aveugle sur un lot d'aimants fournis par un fournisseur. Les mesures sont présentées ci-après et montrent la validité du procédé de contrôle. Il apparaît que les mesures obtenues sont en adéquation avec les données fournies par le fournisseur.

Le tableau 1 présente les mesures pour les aimants de type N52. Les deux premières valeurs d'angle correspondent aux mesures faites par deux fournisseurs notés fournisseur 1 et fournisseur 2. Les mesures obtenues par mise en oeuvre du procédé sont ajoutées : à savoir la mesure du moment magnétique, puis la mesure de l'angle de déviation. Il est à noter que deux mesures d'angle ont été systématiquement faites de façon à avoir un estimateur de la dispersion des mesures angulaires.

*Tableau 1 : Résultats sur les aimants de type N52*

| Numéro aimant | Angle(°) Fournisseur 1 | Angle(°) Fournisseur 2 | Moment magnétique (A.m²) | Angle(°) 1 Demanderesse | Angle(°) 2 Demanderesse |
|---|---|---|---|---|---|
| N52/1 | 0,30 | 0,26 | 0,198 | 0,36 | 0,42 |
| N52/2 | 0,38 | 0,42 | 0,200 | 0,32 | 0,38 |
| N52/3 | 1,71 | 1,68 | 0,197 | 1,79 | 1,79 |
| N52/4 | 0,56 | 0,77 | 0,194 | 0,63 | 0,70 |

(suite)

| Numéro aimant | Angle(°) Fournisseur 1 | Angle(°) Fournisseur 2 | Moment magnétique (A.m$^2$) | Angle(°) 1 Demanderesse | Angle(°) 2 Demanderesse |
|---|---|---|---|---|---|
| N52/5 | 1,01 | 0,88 | 0,198 | 1,01 | 1,01 |
| N52/6 | 0,55 | 0,47 | 0,199 | 0,42 | 0,50 |
| N52/7 | 0,19 | 0,15 | 0,198 | 0,12 | 0,18 |
| N52/8 | 2,31 | 2,12 | 0,197 | 2,11 | 2,11 |
| N52/9 | 2,36 | 2,46 | 0,169 | 2,52 | 2,52 |
| N52/10 | 1,19 | 1,14 | 0,198 | 1,22 | 1,25 |
| N52/11 | 1,52 | 1,48 | 0,198 | 1,50 | 1,56 |
| N52/12 | 0,16 | 0,11 | 0,197 | 0,12 | 0,06 |
| N52/13 | 0,37 | 0,23 | 0,199 | 0,12 | 0,18 |
| N52/14 | 0,94 | 0,92 | 0,197 | 0,95 | 1,01 |
| N52/16 | 1,19 | 1,03 | 0,196 | 1,02 | 0,99 |
| N52/17 | 1,32 | 1,22 | 0,170 | 1,24 | 1,24 |
| N52/18 | 2,02 | 1,95 | 0,198 | 1,96 | 1,90 |
| N52/19 | 0,50 | 0,72 | 0,197 | 0,71 | 0,77 |
| N52/20 | 0,96 | 1,24 | 0,197 | 1,31 | 1,31 |
| N52/21 | Non connu | Non connu | 0,198 | 0,65 | 0,59 |

Il est à noter que le procédé a mis en évidence deux aimants dont les grades avaient été incorrectement mesurés. Il s'agit des aimant N° 9 et 17, dont le moment magnétique est celui d'un aimant de type N35.

L'écart entre les deux mesures de la demanderesse est de 0,08° au maximum. Les mesures de la demanderesse se rapprochent des mesures précédemment effectuées, dont la dispersion paraît supérieure.

Il est observé une tendance identique pour les résultats des aimants de type N35 (voir tableau 2). Les dispersions des angles mesurés par la demanderesse sont de 0,1° au maximum, soit une valeur voisine de celle précédemment obtenue sur les aimants de type N52.

Une attention particulière est à porter aux aimants N° 5 et 16 pour lesquels les angles proposés par le fournisseur ne sont pas en adéquation avec les angles mesurés par la demanderesse. Après examen, il apparaît que les deux aimants ont été vraisemblablement permutés. Les angles obtenus par la demanderesse pour l'aimant 16 correspondent clairement aux angles fournisseurs pour l'aimant 5 et vice versa. Cette expérience contribue à renforcer la fiabilité du protocole de mesure proposé.

*Tableau 2 : Résultats expérimentaux sur les aimant de type N35*

| Numéro aimant | Angle(°) Fournisseur 1 | Angle(°) Fournisseur 2 | Moment magnétique (A.m$^2$) | Angle(°) 1 Demanderesse | Angle(°) 2 Demanderesse |
|---|---|---|---|---|---|
| N35/1 | 0,78 | 1,10 | 0,170 | 0,96 | 1,03 |
| N35/2 | 0,48 | 0,51 | 0,171 | 0,41 | 0,41 |
| N35/3 | 1,18 | 1,13 | 0,169 | 1,15 | 1,25 |
| N35/4 | 1,67 | 1,88 | 0,169 | 1,73 | 1,80 |
| N35/5 | 1,85 | 1,79 | 0,169 | 0,38 | 0,38 |
| N35/7 | 0,27 | 0,24 | 0,170 | 0,21 | 0,28 |
| N35/8 | 0,85 | 0,92 | 0,167 | 0,98 | 1,05 |

(suite)

| Numéro aimant | Angle(°) Fournisseur 1 | Angle(°) Fournisseur 2 | Moment magnétique (A. $m^2$) | Angle(°) 1 Demanderesse | Angle(°) 2 Demanderesse |
|---|---|---|---|---|---|
| N35/9 | 1,39 | 1,33 | 0,169 | 1,25 | 1,32 |
| N35/14 | 0,23 | 0,25 | 0,170 | 0,14 | 0,24 |
| N35/16 | 0,55 | 0,45 | 0,167 | 1,75 | 1,82 |
| N35/17 | 0,30 | 0,31 | 0,169 | 0,28 | 0,35 |
| N35/19 | 0,62 | 0,62 | 0,168 | 0,49 | 0,56 |

Il est à rappeler que les mesures précédentes ont été faites *en aveugle,* c'est-à-dire sans avoir a priori une idée du résultat à obtenir.

*Conclusions*

Selon un mode de réalisation, il est défini une première direction de mesure D1 comme la direction reliant la première position P1 au centre géométrique de l'aimant 12 et une deuxième direction de mesure D2 comme la direction reliant la deuxième position P2 au centre géométrique de l'aimant 12. La première direction de mesure D1 et la deuxième direction de mesure D2 forment un angle β, dit angle de mesure. L'angle de mesure β est compris entre 85° et 95°.
De préférence, l'angle de mesure β est égal à 90°.
Cela permet de simplifier les formules utilisées à l'étape de calcul, ce qui rend la mise en oeuvre du procédé de contrôle plus aisée.
De manière générale le procédé de contrôle s'applique à tout type d'aimant 12 permanent à symétrie de révolution par rapport à l'axe mécanique Z. En particulier, il est intéressant d'appliquer le procédé à un aimant 12 présentant un évidement central cylindrique permettant l'insertion d'un crayon.

**Revendications**

1. Procédé de contrôle de la fabrication d'un aimant (12) à l'aide d'un capteur (14) propre à émettre un signal en présence d'une induction magnétique et définissant un axe de mesure, l'aimant (12) étant un aimant permanent à symétrie de révolution par rapport à un axe (Z), dit axe mécanique, l'aimant (12) ayant un centre (O) et une dimension maximale ($D_{max}$), le procédé comprenant au moins l'étape suivante :

   a) réaliser une première mesure (B1) d'une composante de l'induction magnétique produite par l'aimant (12) à l'aide du capteur (14) en mettant en oeuvre les sous-étapes suivantes :

   a1) positionner relativement l'aimant (12) et le capteur (14) pour que l'axe mécanique (Z) de l'aimant (12) et l'axe de mesure du capteur (14) soient alignés avec une tolérance de 5 degrés, la distance (OP1) entre le capteur (14) et le centre (O) de l'aimant (12), dite première distance, étant supérieure ou égale à trois fois la dimension maximale ($D_{max}$) de l'aimant (12) et
   a2) déplacer relativement l'aimant (12) et le capteur (14) selon une direction perpendiculaire à l'axe mécanique (Z) de l'aimant (12), la première mesure (B1) correspondant au signal maximal mesuré par le capteur (14) lors du déplacement,

   b) réaliser une deuxième mesure (B2) d'une composante de l'induction magnétique produite par l'aimant (12) à l'aide du capteur (14) en mettant en oeuvre les sous-étapes suivantes :

   b1) positionner le capteur (14) pour que l'axe de mesure du capteur (14) soit perpendiculaire à l'axe mécanique (Z) de l'aimant (12) et soit dans un plan perpendiculaire à l'axe mécanique (Z) de l'aimant (12) passant par un point de l'aimant (12), la distance (OP2) entre le capteur (14) et le centre (O) de l'aimant (12), dite deuxième distance, étant supérieure ou égale à trois fois la dimension maximale ($D_{max}$) de l'aimant (12),
   b2) faire tourner l'aimant (12) par rapport à l'axe mécanique (Z) d'au moins un tour,

b3) mesurer les inductions magnétiques maximale et minimale lors de la rotation de l'aimant (12) à la sous-étape b2), la deuxième mesure (B2) étant obtenue à partir des inductions magnétiques maximale et minimale, et

c) calculer la déviation angulaire (a) du moment magnétique (M) équivalent de l'aimant (12) à partir de la première mesure (B1) et de la deuxième mesure (B2).

2. Procédé selon la revendication 1, dans lequel la première distance (OP1) est supérieure ou égale à dix fois la dimension maximale ($D_{max}$) de l'aimant (12).

3. Procédé selon la revendication 1 ou 2, dans lequel la deuxième distance (OP2) est supérieure ou égale à dix fois la dimension maximale ($D_{max}$) de l'aimant (12).

4. Procédé selon l'une quelconque des revendications 1 à 3, dans lequel à l'étape a1), l'aimant (12) et le capteur (14) sont positionnés relativement pour que l'axe mécanique (Z) de l'aimant (12) soit aligné avec l'axe de mesure du capteur (14).

5. Procédé selon l'une quelconque des revendications 1 à 4, dans lequel à l'étape b1), l'aimant (12) et le capteur (14) sont positionnés relativement pour que l'axe mécanique (Z) de l'aimant (12) soit perpendiculaire avec l'axe de mesure du capteur (14).

6. Procédé selon l'une quelconque des revendications 1 à 5, dans lequel la deuxième mesure (B2) est obtenue en calculant le ratio entre la différence des inductions magnétiques maximale et minimale mesurées à la sous-étape b3) et le nombre 2.

7. Procédé selon l'une quelconque des revendications 1 à 6, dans lequel l'étape c) comporte une sous-étape c1) d'application de la formule suivante :

$$\alpha = \tan^{-1} \frac{B_2}{B_1}$$

Où:

• $B_1$ est la valeur de la composante obtenue à l'étape a),
• $B_2$ est la valeur de la composante obtenue à l'étape b),
• $\alpha$ est la déviation angulaire du moment équivalent par rapport à la verticale de l'induction rémanente de l'aimant (12), et
• $\tan^{-1}$ est l'opération mathématique aussi appelée arctangente.

8. Procédé selon l'une quelconque des revendications 1 à 7, dans lequel l'étape c) comporte une sous-étape c2) de calcul du module du moment équivalent de l'aimant (12) par application de la formule suivante :

$$m = \frac{4\pi r^3}{2 * \mu_0} * \sqrt{B_1^2}$$

Où:

• m est le module du moment équivalent de l'aimant (12),
• r est la distance arithmétique moyenne de la première distance et de la deuxième distance, et
• $\mu_0$ est la perméabilité magnétique du vide.

9. Procédé selon l'une quelconque des revendications 1 à 7, dans lequel le procédé comporte, en outre, une étape d) de comparer la déviation angulaire calculée à une valeur seuil, l'aimant (12) étant considéré comme valable lorsque la déviation angulaire est inférieure ou égale à la valeur seuil.

10. Dispositif de contrôle de la fabrication d'un aimant (12), l'aimant (12) étant un aimant permanent à symétrie de révolution par rapport à un axe (Z), dit axe mécanique, l'aimant (12) ayant un centre (O) et une dimension maximale ($D_{max}$), le dispositif (10) étant adapté à mettre en oeuvre le procédé de contrôle selon l'une quelconque des revendications 1 à 9.

**Patentansprüche**

1. Steuerverfahren der Herstellung eines Magneten (12) mittels eines Sensors (14), der geeignet ist, um in Anwesenheit einer magnetischen Induktion ein Signal auszusenden und eine Messachse zu definieren, wobei der Magnet (12) ein rotationssymmetrischer Permanentmagnet in Bezug auf eine Achse (Z) ist, die als mechanische Achse bezeichnet wird, wobei der Magnet (12) einen Mittelpunkt (O) und eine maximale Abmessung ($D_{max}$) aufweist, das Verfahren umfassend mindestens den folgenden Schritt:

    a) Durchführen einer ersten Messung (B1) einer Komponente der magnetischen Induktion, die von dem Magneten (12) erzeugt wird, mittels des Sensors (14), indem die folgenden Teilschritte ausgeführt werden:

    a1) relatives Positionieren des Magneten (12) und des Sensors (14), sodass die mechanische Achse (Z) des Magneten (12) und die Messachse des Sensors (14) mit einer Toleranz von 5 Grad ausgerichtet sind, wobei der Abstand (OP1) zwischen dem Sensor (14) und der Mitte (O) des Magneten (12), der sogenannte erste Abstand, größer als oder gleich wie das Dreifache der maximalen Abmessung ($D_{max}$) des Magneten (12) ist, und
    a2) relatives Bewegen des Magneten (12) und des Sensors (14) in einer Richtung senkrecht zu der mechanischen Achse (Z) des Magneten (12), wobei die erste Messung (B1) dem maximalen Signal entspricht, das von dem Sensor (14) während der Bewegung gemessen wird,

    b) Durchführen einer zweiten Messung (B2) einer Komponente der magnetischen Induktion, die von dem Magneten (12) erzeugt wird, mittels des Sensors (14), indem die folgenden Teilschritte ausgeführt werden:

    b1) Positionieren des Sensors (14), sodass die Messachse des Sensors (14) senkrecht zu der mechanischen Achse (Z) des Magneten (12) ist und in einer Ebene ist, die senkrecht zu der mechanischen Achse (Z) des Magneten (12) durch einen Punkt des Magneten (12) verläuft, wobei der Abstand (OP2) zwischen dem Sensor (14) und der Mitte (O) des Magneten (12), der sogenannte zweite Abstand, größer als oder gleich wie das Dreifache der maximalen Abmessung ($D_{max}$) des Magneten (12) ist,
    b2) Drehen des Magneten (12) in Bezug auf die mechanische Achse (Z) um mindestens eine Umdrehung,
    b3) Messen der maximalen und minimalen magnetischen Induktionen bei der Drehung des Magneten (12) in Teilschritt b2), wobei die zweite Messung (B2) aus der maximalen und der minimalen magnetischen Induktion erlangt wird, und

    c) Berechnen der Winkelabweichung (a) des äquivalenten magnetischen Moments (M) des Magneten (12) aus der ersten Messung (B1) und der zweiten Messung (B2).

2. Verfahren nach Anspruch 1, wobei der erste Abstand (OP1) größer als oder gleich wie das Zehnfache der maximalen Abmessung ($D_{max}$) des Magneten (12) ist.

3. Verfahren nach Anspruch 1 oder 2, wobei der zweite Abstand (OP2) größer als oder gleich wie das Zehnfache der maximalen Abmessung ($D_{max}$) des Magneten (12) ist.

4. Verfahren nach einem der Ansprüche 1 bis 3, wobei in Schritt a1) der Magnet (12) und der Sensor (14) relativ positioniert werden, sodass die mechanische Achse (Z) des Magneten (12) mit der Messachse des Sensors (14) ausgerichtet ist.

5. Verfahren nach einem der Ansprüche 1 bis 4, wobei in Schritt b1) der Magnet (12) und der Sensor (14) relativ positioniert werden, dass die mechanische Achse (Z) des Magneten (12) senkrecht zu der Messachse des Sensors (14) ist.

6. Verfahren nach einem der Ansprüche 1 bis 5, wobei die zweite Messung (B2) durch Berechnen des Verhältnisses zwischen der Differenz der maximalen und der minimalen magnetischen Induktion, die in Teilschritt b3) gemessen wurden, und der Zahl 2 erlangt wird.

7.  Verfahren nach einem der Ansprüche 1 bis 6, wobei Schritt c) einen Teilschritt c1) einer Anwendung der folgenden Formel umfasst:

$$\alpha = \tan^{-1}\frac{B_2}{B_1}$$

Wobei:

• $B_1$ der Wert der in Schritt a) erlangten Komponente ist,
• $B_2$ der Wert der in Schritt b) erlangten Komponente ist,
• $\alpha$ die Winkelabweichung des äquivalenten Moments von der Vertikalen der remanenten Induktion des Magneten (12) ist, und
• $\tan^{-1}$ die mathematische Operation ist, die auch als Arkustangens bezeichnet wird.

8.  Verfahren nach einem der Ansprüche 1 bis 7, wobei Schritt c) einen Teilschritt c2) zum Berechnen des Moduls des äquivalenten Moments des Magneten (12) durch Anwendung der folgenden Formel umfasst:

$$m = \frac{4\pi r^3}{2*\mu_0} * \sqrt{B_1^2}$$

Wobei:

• m das Modul des äquivalenten Moments des Magneten (12) ist,
• r der mittlere arithmetische Abstand des ersten und des zweiten Abstands ist, und
• $\mu_0$ die magnetische Permeabilität des Vakuums ist.

9.  Verfahren nach einem der Ansprüche 1 bis 7, wobei das Verfahren ferner einen Schritt d) eines Vergleichens der berechneten Winkelabweichung mit einem Schwellenwert umfasst, wobei der Magnet (12) als gültig betrachtet wird, wenn die Winkelabweichung kleiner als oder gleich wie der Schwellenwert ist.

10. Steuervorrichtung der Herstellung eines Magneten (12), wobei der Magnet (12) ein rotationssymmetrischer Permanentmagnet in Bezug auf eine Achse (Z) ist, die als mechanische Achse bezeichnet wird, wobei der Magnet (12) eine Mitte (O) und eine maximale Abmessung ($D_{max}$) aufweist, wobei die Vorrichtung (10) geeignet ist, um das Steuerverfahren nach einem der Ansprüche 1 bis 9 auszuführen.

**Claims**

1.  A method for controlling the production of a magnet (12) using a sensor (14) able to emit a signal in the presence of a magnetic induction and defining a measuring axis, the magnet (12) being a permanent magnet with symmetry of revolution relative to an axis (Z), called mechanical axis, the magnet (12) having a center (O) and a maximum dimension ($D_{max}$), the method comprising at least the following step:

    a) performing a first measurement (B1) of a component of the magnetic induction produced by the magnet (12) using the sensor (14) by implementing the following sub-steps:

        a1) relative positioning of the magnet (12) and the sensor (14) so that the mechanical axis (Z) of the magnet (12) and the measuring axis of the sensor (14) are aligned with an allowance of 5 degrees, the distance (OP1) between the sensor (14) and the center (O) of the magnet (12), called first distance, being greater than or equal to three times the maximum dimension ($D_{max}$) of the magnet (12), and
        a2) relative movement of the magnet (12) and the sensor (14), along a direction perpendicular to the mechanical axis (Z) of the magnet (12), the first measurement (B1) corresponding to the maximum signal measured by the sensor (14) during the movement,

    b) performing a second measurement (B2) of a component of the magnetic induction produced by the magnet (12) using the sensor (14) by implementing the following sub-steps:

b1) positioning the sensor (14) so that the measuring axis of the sensor (14) is perpendicular to the mechanical axis (Z) of the magnet (12) and is in a plane perpendicular to the mechanical axis (Z) of the magnet (12) passing through a point of the magnet (12), the distance (OP2) between the sensor (14) and the center (O) of the magnet (12), called second distance (OP2), being greater than or equal to three times the maximum dimension $(D_{max})$ of the magnet (12),
b2) rotating the magnet (12) relative to the mechanical axis (Z) by at least one revolution,
b3) measuring the maximum and minimum magnetic inductions during the rotation of the magnet (12) in sub-step b2), the second measurement (B2) being obtained from maximum and minimum magnetic inductions, and

c) calculating the angular deviation (a) of the equivalent magnetic moment (M) of the magnet (12) from the first measurement (B1) and the second measurement (B2).

2. The method according to claim 1, wherein the first distance (OP1) is greater than or equal to ten times the maximum dimension $(D_{max})$ of the magnet (12).

3. The method according to claim 1 or 2, wherein the second distance (OP2) is greater than or equal to ten times the maximum dimension $(D_{max})$ of the magnet (12).

4. The method according to any one of claims 1 to 3, wherein in step a1), the magnet (12) and the sensor (14) are relatively positioned such that the mechanical axis (Z) of the magnet (12) is aligned with the measuring axis of the sensor (14).

5. The method according to any one of claims 1 to 4, wherein in step b1), the magnet (12) and the sensor (14) are relatively positioned such that the mechanical axis (Z) of the magnet (12) is perpendicular to the measuring axis of the sensor (14).

6. The method according to any one of claims 1 to 5, wherein the second measurement (B2) is obtained by calculating the ratio between the difference in the maximum and minimum magnetic inductions obtained in sub-step b3) and the number 2.

7. The method according to any one of claims 1 to 6, wherein step c) includes a sub-step c1) for applying the following formula:

$$\alpha = \tan^{-1}\frac{B_2}{B_1}$$

Where:

• $B_1$ is the value of the component obtained in step a),
• $B_2$ is the value of the component obtained in step b),
• $\alpha$ is the angular deviation of the equivalent moment relative to the vertical of the remanent induction of the magnet (12), and
• $\tan^{-1}$ is the mathematical operation also called arctangent.

8. The method according to any one of claims 1 to 7, wherein step c) includes a sub-step c2) for calculating the modulus of the equivalent moment of the magnet (12) by applying the following formula:

$$m = \frac{4\pi r^3}{2 * \mu_0} * \sqrt{B_1^2}$$

Where:

• m is the modulus of the equivalent moment of the magnet (12),
• r is the mean arithmetic distance of the first distance and the second distance, and
• $\mu_0$ is the magnetic permeability of the vacuum.

9. The method according to any one of claims 1 to 7, wherein the method further includes a step d) for comparing the calculated angular deviation to a threshold value, the magnet (12) being considered valid when the angular deviation is less than or equal to the threshold value.

10. A device for controlling the production of a magnet (12), the magnet (12) being a permanent magnet with symmetry of revolution relative to an axis (Z), called mechanical axis, the magnet (12) having a center (O) and a maximum dimension ($D_{max}$), the device (10) being adapted to carry out a method for controlling according to any one of claims 1 to 9.

## FIG.1

## FIG.2

# FIG.3

Effet sur l'induction magnétique

Déviation angulaire (°)

# FIG.4

$\times P_1$

$\times$
$P_2$

$\times$
0  12

$\odot$
Z

FIG.5

32

40

42

12

34

FIG.6

10

14  36  30

Y
Z $\odot$ → X

38

$\times$
$P_1 = P_2$

$\times$
0  12

$\odot$
Z

FIG.7

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 1813910 A2
- US 20110025311 A1
- US 2014176126 A